(19) Europäisches Patentamt
European Patent Office
Office européen des brevets

(11) **EP 3 796 530 A1**

(12) **EUROPEAN PATENT APPLICATION**
published in accordance with Art. 153(4) EPC

(43) Date of publication:
24.03.2021 Bulletin 2021/12

(51) Int Cl.:
*H02M 1/00* *(2006.01)*

(21) Application number: 19811772.3

(22) Date of filing: 27.05.2019

(86) International application number:
PCT/CN2019/088540

(87) International publication number:
WO 2019/228301 (05.12.2019 Gazette 2019/49)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 29.05.2018 CN 201810533599

(71) Applicant: ZTE Corporation
Shenzhen, Guangdong 518057 (CN)

(72) Inventors:
• GAO, Yun
Shenzhen, Guangdong 518057 (CN)
• REN, Yaqi
Shenzhen, Guangdong 518057 (CN)

(74) Representative: **Betten & Resch**
**Patent- und Rechtsanwälte PartGmbB**
**Maximiliansplatz 14**
**80333 München (DE)**

(54) **CURRENT-EQUALISING CONTROL METHOD, APPARATUS, AND DEVICE, AND COMPUTER READABLE STORAGE MEDIUM**

(57) Disclosed are a current-sharing control method, apparatus, and device and a computer-readable storage medium. The method includes acquiring a sampling signal of a power circuit (S10), converting the sampling signal into a digital signal (S20), calibrating the digital signal to obtain a correspondence between the sampling signal and an output current of the power circuit (S30), and performing current-sharing control on at least one power supply modules according to the correspondence (S40).

FIG. 1

**Description**

**TECHNICAL FIELD**

The present disclosure relates to, but is not limited to, the technical field of communication.

**BACKGROUND**

In the field of communication power supplies, to satisfy the requirements of load power and reliability on power supplying, it is significant to connect multiple power supply modules in parallel in use for higher power output. The use of the parallel power supply modules offers the advantages of easy expansion, good compatibility and reliable redundant backup. The pursuit of these advantages promotes the research and development of the power supplies in terms of parallel current sharing technologies.

When multiple identical power supplies work in parallel, they may have different output currents from each other due to the parameter differences of their circuit components, and consequently different electrical and thermal stresses during operation, thereby impairing the operation of an entire parallel system in terms of reliability. Therefore, the power supply modules must have a function of parallel current sharing, to ensure the reliability in power supplying of the system.

With the evolution of digitization in the field of power supplies, highly integrated and easy-to-transplant digital power supplies have become the trend for the power source systems. As an important part of the design of the digital power supplies, a digital control scheme for the current-sharing technology has been extremely urgent.

**SUMMARY**

In an aspect of the present disclosure, a current-sharing control method comprises following steps: acquiring a sampling signal of a power circuit; converting the sampling signal into a digital signal; calibrating the digital signal to obtain a correspondence between the sampling signal and an output current of the power circuit; and performing current-sharing control on at least one power supply modules according to the correspondence.

In another aspect of the present disclosure, a current-sharing control device comprises a sampling module configured to acquire a sampling signal of a power circuit, a conversion module configured to convert the sampling signal into a digital signal, a calibration module configured to calibrate the digital signal to obtain a correspondence between the sampling signal and an output current, and a control module configured to perform current-sharing control on at least one power supply module according to the correspondence.

In another aspect of the present disclosure, an electronic device comprises a memory and a processor, wherein the memory has at least one computer program stored thereon, and the processor is configured to executes the current-sharing control method of any one of claims 1-4 when executing the computer program.

In another aspect of the present disclosure, a computer-readable storage medium has at least one computer program stored thereon that, when executed by a processor, cause the processor to perform the current-sharing control method of to any one of claims 1-4.

**BRIEF DESCRIPTION OF DRAWINGS**

Fig. 1 is a flow chart of a current-sharing control method according to an embodiment of the present disclosure:

Fig. 2 is a hardware circuit diagram of a current-sharing control scheme of a power supply module according to an embodiment of the present disclosure;

Fig. 3 is a schematic diagram of the parallel operation of multiple power supply modules according to an embodiment of the present disclosure;

Fig. 4 is a flow chart of step S40 in the current-sharing control method shown in Fig. 1;

Fig. 5 is a hardware circuit diagram of a current-sharing control scheme of a power supply module according to an embodiment of the present disclosure;

Fig. 6 is a hardware circuit diagram of a current-sharing control scheme of a power supply module according to an embodiment of the present disclosure;

Fig. 7 is a hardware circuit diagram of a current-sharing control scheme of a power supply module according to an embodiment of the present disclosure;

Fig. 8 is a schematic structural block diagram of a current-sharing control apparatus according to an embodiment of the present disclosure;

Fig. 9 is a schematic structural block diagram of a control module in the current-sharing control apparatus shown in Fig. 8; and

Fig. 10 is a schematic structural block diagram of a calibration module in the current-sharing control apparatus shown in Fig. 8.

## DETAILED DESCRIPTION

To make the technical problems to be solved by the present disclosure, the technical schemes adopted to solve the technical problems, and the beneficial effects provided by the technical schemes more obvious and clearer, the present disclosure will be further described in detail below by embodiments with reference to the drawings. It should be appreciated that the specific embodiments described herein are merely intended to explain the disclosure and are not intended to limit the disclosure.

With a digital current-sharing control scheme, the sampling on the current of a power supply is usually performed by an output current sampling and amplifying module, in which a sampling resistance, a copper trace of a printed circuit board or an internal resistance of a power device is usually used for sampling. The sampled voltages may be different because of the difference in parameters of the sampling resistance, the copper trace of the printed circuit board or the resistance of power device, even though equal currents flow through these components. When the sampled voltages are directly used for current-sharing control, the difference of the sampled voltages may lead to deviation in current-sharing control, thereby impairing the current-sharing performance of the entire system and consequently the reliability of long-term operation of the system.

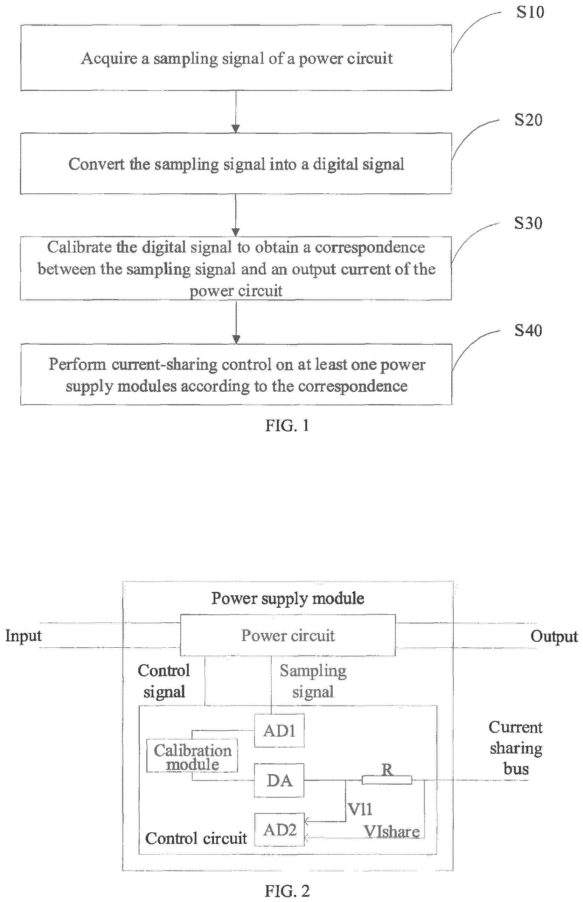

Fig. 1 is a flow chart of a current-sharing control method according to an embodiment of the present disclosure.

As shown in Fig. 1, the current-sharing control method according to an embodiment of the present disclosure may include steps of S 10 to S40.

At S10, a sampling signal of a power circuit is acquired.

At S20, the sampling signal is converted into a digital signal.

At S30, the digital signal is calibrated to obtain a correspondence between the sampling signal and an output current.

At S40, current-sharing control is performed on at least one power supply module according to the correspondence.

According to an embodiment of the present disclosure, the correspondence between the sampling signal and the output current is obtained by converting and calibrating the sampling signal, such that the deviation caused by the difference between various sampling circuits on the current-sharing control of the parallel power supply modules is eliminated, the current-sharing performance of the power supply modules is improved, and consequently the reliability of the system is enhanced.

Fig. 2 is a hardware circuit diagram of a current-sharing control scheme of a power supply module according to an embodiment of the present disclosure.

In some embodiments, as shown in Fig. 2, the hardware circuit diagram of the current-sharing control scheme of the power supply module includes a power circuit and a control circuit. Two ends of the power circuit are respectively connected to an input end and an output end of the power supply module. The control circuit includes a first analog-to-digital conversion unit (AD1), a calibration module, a digital-to-analog conversion unit (DA), a second analog-to-digital conversion unit (AD2) and a current-sharing bus resistor (R). The sampling signal sampled from the power circuit is converted into a digital signal by the first analog-to-digital conversion unit (AD1), and the digital signal is calibrated through an algorithm stored in the calibration module to obtain a correspondence between the sampling signal and the output current. Thereafter, current-sharing control may be performed on the power supply module according to the correspondence between the obtained sampling signal and the output current, so that the output current of each power supply module is only related to the sampling signal, thereby eliminating the influence of the difference of sampling circuits on the operation of the current-sharing circuit.

As the calculated output signal of the power supply module (VI1 shown in the figure) needs to be calculated in real time, a program for calculating VI1 may be set as an interrupt program of the control circuit, or the calculation may be performed by a dedicated hardware circuit, to speed up the calculation. In another embodiment, the hardware circuit for obtaining VI1 may also be built outside the control circuit. The specific implementation for calculating VI1 will be described in detail later.

If the difference between the calculated output signal VI1 of the power supply module and a voltage VIshare of the current-sharing bus is greater than a first threshold which is a self-defined value greater than or equal to zero, the power circuit may be controlled upon a control signal that a reference value for the output voltage of the power supply module is reduced for the purpose of reducing the output current of the power supply module. On the other hand, if the difference between the technical output signal VI1 of the power supply module and the voltage VIshare of the current-sharing bus is less than a second threshold which is a self-defined value less than or equal to zero, the power circuit may be controlled upon a control signal that the reference value for the output voltage of the power supply module is increased for the purpose of increasing the output current of the power supply module. In addition, if the difference between the calculated output signal VI1 of the power supply module and the voltage VIshare of the current-sharing bus is less than or equal to the first threshold and greater than or equal to the second threshold, the reference value for the output voltage of the power supply module may not be adjusted.

According to an embodiment of the present disclosure, as no high-precision sampling resistor is required in the sampling circuit, the power supply can have a greatly reduced layout area, reduced cost, and improved overall conversion efficiency.

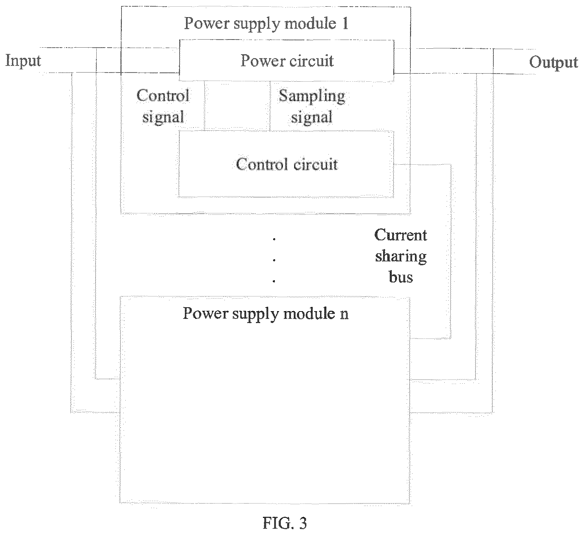

Fig. 3 is a schematic diagram of the parallel operation of multiple power supply modules according to an embodiment of the present disclosure.

As shown in Fig. 3, the control circuit of each of the power supply modules obtains the correspondence between the respective sampling signal and the output current, and performs current sharing control on the power circuit of the power supply module according to the obtained correspondence, whereby the current-sharing performance of each of the power supply modules is improved and consequently the reliability of the system is improved.

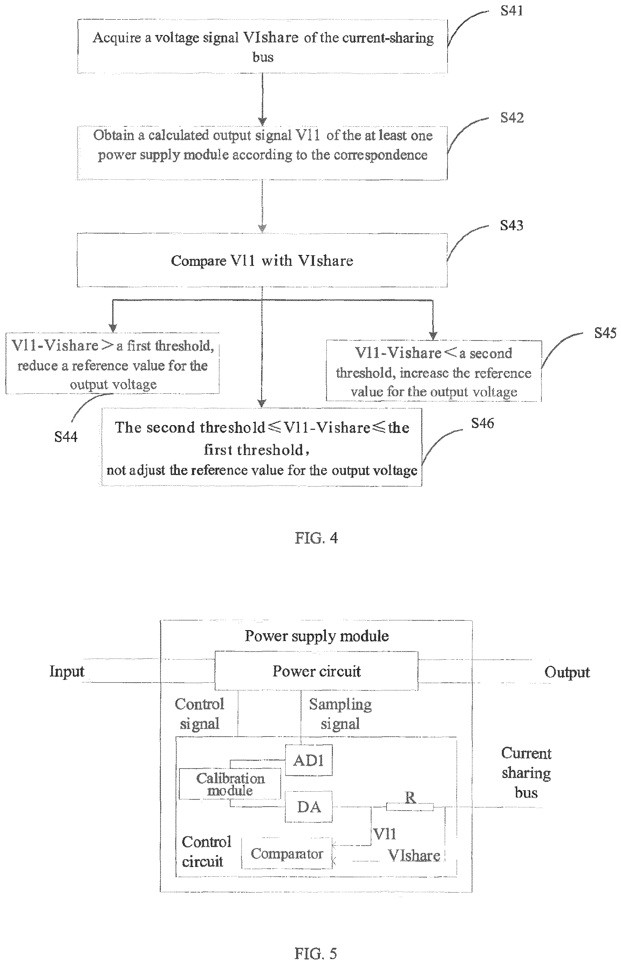

Fig. 4 is a flow chart of step S40 in the current-sharing control method shown in Fig. 1.

As shown in Fig. 4, the power supply module shown in Fig. 2 is connected to the current-sharing bus via the current-sharing bus resistor R, and step S40 in the embodiment of the current-sharing control method shown in Fig. 1 may include steps of S41 to S46.

At S41, a voltage signal VIshare of the current-sharing bus is acquired.

At S42, a calculated output signal VI1 of the power supply module is obtained according to the correspondence.

At S43, the calculated output signal VI1 of the power supply module is compared with the voltage VIshare of the current-sharing bus.

The comparison of the calculated output signal VI1 and the voltage VIshare of the current-sharing bus may be performed in the second analog-to-digital conversion unit (AD2) shown in Fig. 2. In another embodiment, as shown in Fig. 5, the comparison of the calculated output signal VI1 and the voltage VIshare of the current-sharing bus may be performed by an operational amplifier or comparator.

At S44, if the difference between the calculated output signal VI1 of the power supply module and the voltage VIshare of the current-sharing bus is greater than the first threshold, the reference value for the output voltage of the power supply module is reduced.

At S45, if the difference between the calculated output signal VI1 of the power supply module and the voltage VIshare of the current-sharing bus is less than the second threshold, the reference value for the output voltage of the power supply module is increased.

At S46, if the difference between the calculated output signal VI1 of the power supply module and the voltage VIshare of the current-sharing bus is less than or equal to the first threshold and greater than or equal to the second threshold, the reference value for the output voltage of the power supply module is not adjusted.

In some embodiments, step S30 in the embodiment of the current-sharing control method shown in Fig. 1 may include one of the following steps: calibrating the digital signal by using a two-point method to obtain a linear correspondence between the sampling signal and the output current; calibrating the digital signal by using a quadratic curve fitting method to obtain a quadratic function correspondence between the sampling signal and the output current; calibrating the digital signal by using a piecewise linear method to obtain a piecewise linear correspondence between the sampling signal and the output current; and calibrating the digital signal to obtain a self-defined function correspondence between the sampling signal and the output current.

In the case where the digital signal is calibrated by using the two-point method, for example, as shown in Fig. 2, when the output current of the power supply module is I10, the obtained sampling signal is V10, and the sampling signal is analog-to-digital converted by the first analog-to-digital conversion unit (AD1) into the digital signal D10. In addition, when the output current of the power supply module is I20, the obtained sampling signal is V20, and the sampling signal is analog-to-digital converted by the first analog-to-digital conversion unit (AD1) into the digital signal D20. In the case of using the two-point method for calibration, the correspondence between the sampling signal V and the output current I is as follows:

$$V = k*I + b \qquad (1)$$

after the above data are brought in, the relations may be as:

$$D10 = k*I10 + b \qquad (2)$$

$$D20 = k*I20 + b \qquad (3)$$

and after deduction:

$$k = (D20 - D10)/(I20 - I10) \qquad (4)$$

$$b = D10 - k*I10 \qquad (5)$$

In this way, the relation between the output current I and the sampling signal V may be as:

$$I = (V - b)/k \qquad (6)$$

As different power supply modules may have different internal resistances, they may also have different k and b values. The output current of a power supply modules may be calculated through the above relation (6) based on the measured voltage value. Then, by using a reference value same as the reference value for the output voltage, the current value is converted into the calculated output signal VI1 of the power supply module by the digital-to-analog conversion unit (DA), which is output to the current-sharing bus by the current-sharing bus resistor R.

In the case where the digital signal is calibrated by using the quadratic curve fitting method, the function correspondence between the sampling signal and the output current signal may be:

$$V = A*I^2 + B*I + C \qquad (7)$$

Multi-point sampling may be performed as required, and coefficients A, B and C corresponding to each power supply module may be calculated. Similar to the two-point method calibration, the output current of the power supply module may be calculated according to the measured voltage value through the deduced relation between the output current I and the sampling signal V. Then, by using a reference value same as the reference value for the output voltage, the current value is converted into the calculated output signal VI1 of the power supply module by the digital-to-analog conversion unit (DA), which is output to the current-sharing bus by the current-sharing bus resistor R.

In the case where the digital signal is calibrated by using the piecewise linear method, for example, when the output current of the power supply module is 110, the obtained sampling signal is V10 and the corresponding digital signal is D10; when the output current of the power supply module is 120, the obtained sampling signal is V20 and the corresponding digital signal is D20; when the output current of the power supply module is 130, the obtained sampling signal is V30 and the corresponding digital signal is D30; and when the output current of the power supply module is 140, the obtained sampling signal is V40 and the corresponding digital signal is D40. In the case where the piecewise linear method is used for calibration, if the output current ranges from 110 to 120 (including the endpoints 110 and 120), the correspondence between the sampling signal V and the output current I is:

$$V = k1*I + b1 \qquad (8)$$

if the output current ranges from 130 to 140 (including the endpoints 130 and 140), the correspondence between the sampling signal V and the output current I is:

$$V=k2*I+b2 \qquad (9)$$

after deduction:

$$k1=(D20-D10)/(I20-I10)$$

$$b1=D10-k1*I10$$

$$k2=(D40-D30)/(I40-I30)$$

$$b2=D30-k2*I30$$

In this way, parameters such as k1, b1, k2 and b2 of each power supply module may be obtained. Although in the above embodiment the piecewise linear method is described with two divided interval segments for calculation, the present disclosure is not limited to this, and for example, three or more divided interval segments may be used for calculation as required.

In some cases, the correspondence between the sampling signal and the output current may not be a linear correspondence or quadratic function correspondence, but may be a cubic function or a higher order function correspondence. According to the actual situation, a self-defined function correspondence between the sampling signal and the output current may be obtained.

A current-sharing mode of the current-sharing bus may be average current-sharing, maximum current-sharing or other current-sharing modes.

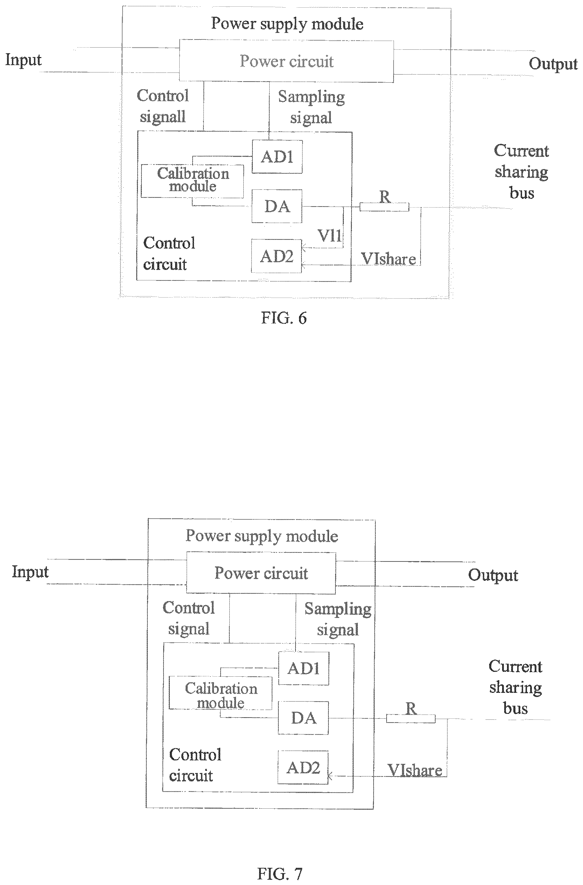

Fig. 6 is a hardware circuit diagram of a current-sharing control scheme of a power supply module according to an embodiment of the present disclosure.

As shown in Fig. 6, compared with the hardware circuit diagram shown in Fig. 2, in the hardware circuit diagram according to this embodiment, the current-sharing bus resistor R is arranged inside the power supply module, but connected to the external control circuit.

Fig. 7 is a hardware circuit diagram of a current-sharing control scheme of a power supply module according to an embodiment of the present disclosure.

As shown in Fig. 7, compared with the hardware circuit diagram shown in Fig. 2, in the hardware circuit diagram according to this embodiment, the current-sharing bus resistor R is arranged outside the power supply module.

In some embodiments, because the power supply module has calculated the output current of the power supply module according to the measured voltage value, the digital-to-analog conversion is not performed on the output current. In this case, the calibration algorithm may be linear calibration, high-order function calibration or other self-defined calibration algorithms. The current-sharing control mode may be average current-sharing, maximum current-sharing or other current-sharing modes.

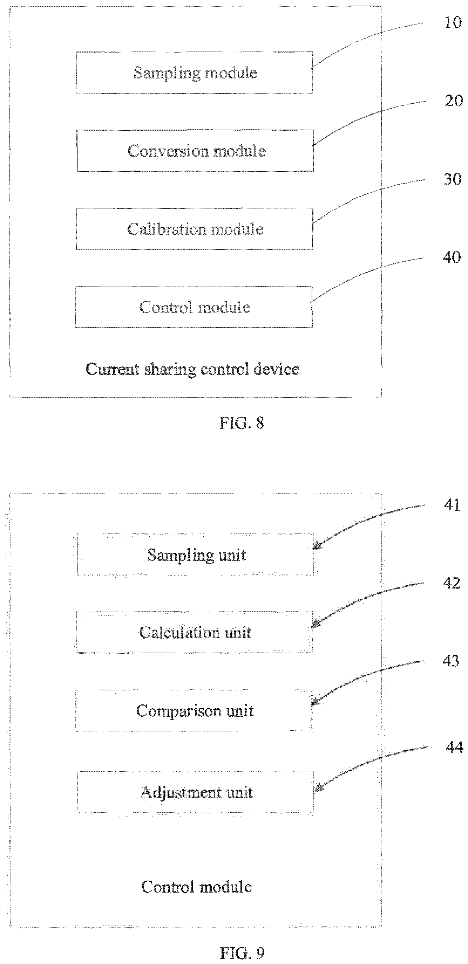

Fig. 8 is a schematic structural block diagram of a current-sharing control device according to an embodiment of the present disclosure.

As shown in Fig. 8, the current-sharing control device according to this embodiment may include a sampling module 10, a conversion module 20, a calibration module 30 and a control module 40.

The sampling module is configured to obtain a sampling signal of a power circuit.

The conversion module 20 is configured to convert the sampling signal into a digital signal.

The calibration module 30 is configured to calibrate the digital signal to obtain a correspondence between the sampling signal and an output current.

The control module 40 is configured to perform current-sharing control on at least one power supply module according to the correspondence.

According to the embodiment of the present disclosure, the correspondence between the sampling signal and the output current is obtained by converting and calibrating the sampling signal, whereby the deviation caused by the difference between various sampling circuits on the current-sharing control of the parallel power supply modules is eliminated, the current-sharing performance of the power supply module is improved, and consequently the overall reliability of the system is enhanced.

Fig. 9 is a schematic structural block diagram of a control module 40 in the current-sharing control apparatus shown in Fig. 8.

As shown in Fig. 9, in this embodiment, the control module 40 includes a sampling unit 41, a calculation unit 42, a comparison unit 43 and an adjustment unit 44.

The sampling unit 41 is configured to acquire a voltage signal of the current-sharing bus.

The calculation unit 42 configured to obtain a calculated output signal of the power supply module according to the correspondence.

The comparison unit 43 is configured to compare the calculated output signal of the power supply module with the voltage of the current-sharing bus. The comparison unit 43 may be implemented as the second analog-to-digital conversion unit AD2 shown in Fig. 2. In another embodiment, the comparison unit 43 may also be implemented by the comparator as shown in Fig. 5.

The adjustment unit 44 is configured to: if the difference between the calculated output signal of the power supply module and the voltage of the current-sharing bus is greater than a first threshold, reduce a reference value for the output voltage of the power supply module; if the difference between the calculated output signal of the power supply module and the voltage of the current-sharing bus is less than a second threshold, increase the reference value for the output voltage of the power supply module; and if the difference between the calculated output signal of the power supply module and the voltage of the current-sharing bus is less than or equal to the first threshold and greater than or equal to the second threshold, not adjust the reference value for the output voltage of the power supply module.

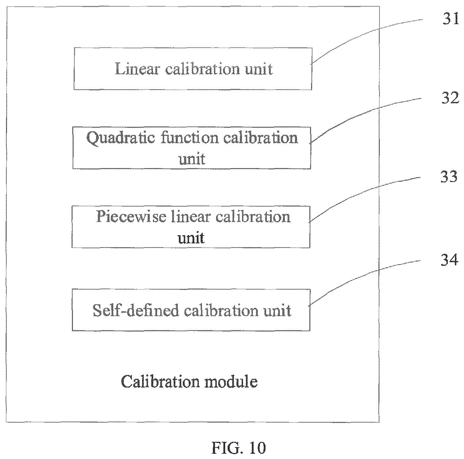

Fig. 10 is a schematic structural block diagram of a calibration module 30 in the current-sharing control apparatus shown in Fig.8.

As shown in Fig. 10, in this embodiment, the calibration module 30 may include at least one of a linear calibration unit 31, a quadratic function calibration unit 32, a piecewise linear calibration unit 33 and a self-defined calibration unit 34.

The linear calibration unit 31 is configured to calibrate the digital signal by using a two-point method to obtain a linear correspondence between the sampling signal and the output current.

The quadratic function calibration unit 32 is configured to calibrate the digital signal by using a quadratic curve fitting method to obtain a quadratic function correspondence between the sampling signal and the output current.

The piecewise linear calibration unit 33 is configured to calibrate the digital signal by using a piecewise linear method to obtain a piecewise linear correspondence between the sampling signal and the output current.

The self-defined calibration unit 34 is configured to calibrate the digital signal to obtain a self-defined function correspondence between the sampling signal and the output current.

Various calibration methods have been described above in detail and will not be repeated below.

In an embodiment of the present disclosure, an electronic device comprising a memory and a processor is further provided, in which at least one computer program executed by the processor is stored on the memory, and when executing the computer program, the processor performs a current sharing control method according to the embodiments of the present disclosure.

An embodiment of the present disclosure further provides a computer-readable storage medium storing a computer program thereon, when executed by a processor, the computer program causes the processor to perform a current sharing control method according to the embodiments of the present disclosure.

According to the current sharing control method, device and computer readable storage medium of the embodiments of the present disclosure, the correspondence between the sampled signal and the output current is obtained by converting and calibrating the sampled signal, whereby the deviation to the current sharing control of the parallel power supply modules caused by the difference among the sampling circuits can be eliminated, the current sharing effect of the power supply module is improved, and the reliability of the system is further improved.

With the description of the above embodiments, those skilled in the art will clearly understand that the methods of the above embodiments may be implemented by software plus a necessary general hardware platform, and of course may also be implemented by hardware only. Based on such an understanding, the technical schemes of the present disclosure may be embodied in the form of a software product stored on a storage medium (e.g., ROM/RAM, magnetic disk, optical disk, flash, etc.) including several instructions for causing a terminal device (which may be a mobile phone, computer, server, air conditioner, or network device, etc.) to perform the methods described in the various embodiments of the present disclosure.

Embodiments of the present disclosure are described above with reference to the accompanying drawings, and are not thereby intended to limit the scope of the present disclosure. Any modifications, equivalent replacements and improvements made by those skilled in the art without departing from the gist of the present disclosure are intended to be within the scope of the present disclosure.

**Claims**

1. A current-sharing control method, comprising following steps:

acquiring a sampling signal of a power circuit;
converting the sampling signal into a digital signal;
calibrating the digital signal to obtain a correspondence between the sampling signal and an output current of the power circuit; and
performing current-sharing control on at least one power supply modules according to the correspondence.

2. The current-sharing control method of claim 1, wherein the at least one power supply module is connected to a current-sharing bus by a current-sharing bus resistor, and the step of performing current-sharing control on the at least one power supply module according to the correspondence comprises:

acquiring a voltage signal of the current-sharing bus;
obtaining a calculated output signal of the at least one power supply module according to the correspondence;
comparing the calculated output signal of the least one power supply module with the voltage signal of the current-sharing bus; and
in response to the difference, between the calculated output signal of the power supply module and the voltage signal of the current-sharing bus, being greater than a first threshold, reducing a reference value for the output voltage of the power supply module;
in response to the difference, between the calculated output signal of the power supply module and the voltage of the current-sharing bus, being less than a second threshold, increasing the reference value for the output voltage of the power supply module; and
in response to the difference, between the calculated output signal of the power supply module and the voltage of the current-sharing bus, being less than or equal to the first threshold and greater than or equal to the second threshold, not adjusting the reference value for the output voltage of the power supply module.

3. The current-sharing control method of claim 2, wherein the step of calibrating the digital signal to obtain a correspondence between the sampling signal and the output current comprises one of the followings:

calibrating the digital signal by using a two-point method to obtain a linear correspondence between the sampling signal and the output current;
calibrating the digital signal by using a quadratic curve fitting method to obtain a quadratic function correspondence between the sampling signal and the output current;
calibrating the digital signal by using a piecewise linear method to obtain a piecewise linear correspondence between the sampling signal and the output current; and
calibrating the digital signal to obtain a self-defined function correspondence between the sampling signal and the output current.

4. The current-sharing control method of claim 2, wherein the current-sharing bus resistor is arranged inside the power supply module or externally connected to the power supply module.

5. A current-sharing control device, comprising:

a sampling module, configured to acquire a sampling signal of a power circuit;
a conversion module, configured to convert the sampling signal into a digital signal;
a calibration module, configured to calibrate the digital signal to obtain a correspondence between the sampling signal and an output current; and
a control module, configured to perform current-sharing control on at least one power supply module according to the correspondence.

6. The current-sharing control device of claim 5, wherein the at least one power supply module is connected to a current-sharing bus by a current-sharing bus resistor, and the control module comprises:

a sampling unit, configured to acquire a voltage signal of the current-sharing bus;
a calculation unit, configured to obtain a calculated output signal of the power supply module according to the correspondence;
a comparison unit, configured to compare the calculated output signal of the power supply module with the voltage of the current-sharing bus; and
an adjusting unit, configured to:

in response to the difference, between the calculated output signal of the power supply module and the voltage of the current-sharing bus, being greater than a first threshold, reduce a reference value for the output voltage of the power supply module;

in response to the difference, between the calculated output signal of the power supply module and the voltage of the current-sharing bus, being less than a second threshold, increase the reference value for the output voltage of the power supply module; and

in response to the difference, between the calculated output signal of the power supply module and the voltage of the current-sharing bus, being less than or equal to the first threshold and greater than or equal to the second threshold, not adjust the reference value for the output voltage of the power supply module.

7. The current-sharing control device of claim 6, wherein the calibration module comprises at least one of followings:

a linear calibration unit, configured to calibrate the digital signal by using a two-point method to obtain a linear correspondence between the sampling signal and the output current;

a quadratic function calibration unit, configured to calibrate the digital signal by using a quadratic curve fitting method to obtain a quadratic function correspondence between the sampling signal and the output current;

a piecewise linear calibration unit, configured to calibrate the digital signal by using a piecewise linear method to obtain a piecewise linear correspondence between the sampling signal and the output current; and

a self-defined calibration unit, configured to calibrate the digital signal to obtain a self-defined function correspondence between the sampling signal and the output current.

8. The current-sharing control device of claim 6, wherein the current-sharing bus resistor is arranged inside the power supply module or externally connected to the power supply module.

9. An electronic device, comprising a memory and a processor, wherein the memory has at least one computer program stored thereon, and the processor executes the current-sharing control method of any one of claims 1-4 when executing the computer program.

10. A computer-readable storage medium, having at least one computer program stored thereon that, when executed by a processor, causes the processor to perform the current-sharing control method of any one of claims 1-4.

| Acquire a sampling signal of a power circuit | S10 |

$\downarrow$

| Convert the sampling signal into a digital signal | S20 |

$\downarrow$

| Calibrate the digital signal to obtain a correspondence between the sampling signal and an output current of the power circuit | S30 |

$\downarrow$

| Perform current-sharing control on at least one power supply modules according to the correspondence | S40 |

FIG. 1

Power supply module

Input — Power circuit — Output

Control signal    Sampling signal

Calibration module

AD1

DA — R — Current sharing bus

Control circuit — AD2 — Vll — VIshare

FIG. 2

Power supply module 1

Input

Power circuit

Output

Control signal

Sampling signal

Control circuit

.
.
.

Current sharing bus

Power supply module n

FIG. 3

Acquire a voltage signal VIshare of the current-sharing bus — S41

Obtain a calculated output signal Vl1 of the at least one power supply module according to the correspondence — S42

Compare Vl1 with VIshare — S43

Vl1-Vishare > a first threshold, reduce a reference value for the output voltage — S44

Vl1-Vishare < a second threshold, increase the reference value for the output voltage — S45

The second threshold ≤ Vl1-Vishare ≤ the first threshold, not adjust the reference value for the output voltage — S46

FIG. 4

Power supply module

Input — Power circuit — Output

Control signal — Sampling signal

AD1

Calibration module

DA — R

Current sharing bus

Control circuit — Comparator — Vl1 — VIshare

FIG. 5

Power supply module

Input

Power circuit

Output

Control signall

Sampling signal

AD1

Calibration module

DA

VI1

Control circuit

AD2

VIshare

Current sharing bus

R

FIG. 6

Power supply module

Input

Power circuit

Output

Control signal

Sampling signal

AD1

Calibration module

DA

Control circuit

AD2

VIshare

Current sharing bus

R

FIG. 7

Sampling module — 10

Conversion module — 20

Calibration module — 30

Control module — 40

Current sharing control device

FIG. 8

Sampling unit — 41

Calculation unit — 42

Comparison unit — 43

Adjustment unit — 44

Control module

FIG. 9

Linear calibration unit — 31

Quadratic function calibration unit — 32

Piecewise linear calibration unit — 33

Self-defined calibration unit — 34

Calibration module

FIG. 10

## INTERNATIONAL SEARCH REPORT

| International application No. |
|---|
| **PCT/CN2019/088540** |

**A. CLASSIFICATION OF SUBJECT MATTER**

H02M 1/00(2007.01)i

According to International Patent Classification (IPC) or to both national classification and IPC

**B. FIELDS SEARCHED**

Minimum documentation searched (classification system followed by classification symbols)

HO2M; H03M; H02J

Documentation searched other than minimum documentation to the extent that such documents are included in the fields searched

Electronic data base consulted during the international search (name of data base and, where practicable, search terms used)

CNABS; CNTXT; VEN; CNKI: 均流, 均衡, 功率, 采样, 电压, 电流, 校准, 校正, 误差, 差异, 偏差, 采样误差, 两点法, 二次曲线拟合, 分段线性, 函数, equaliz+, sampl+, collect+, voltage, current, calibrat+, adjust+, correct+, error, function

**C. DOCUMENTS CONSIDERED TO BE RELEVANT**

| Category* | Citation of document, with indication, where appropriate, of the relevant passages | Relevant to claim No. |
|---|---|---|
| A | CN 103580450 A (ZTE CORPORATION) 12 February 2014 (2014-02-12) <br> entire document | 1-10 |
| A | CN 103441491 A (THE 724TH RESEARCH INSTITUTE OF CHINA SHIPBUILDING INDUSTRY CORPORATION) 11 December 2013 (2013-12-11) <br> entire document | 1-10 |
| A | CN 101667729 A (ZTE CORPORATION) 10 March 2010 (2010-03-10) <br> entire document | 1-10 |
| A | DE 2751696 A1 (PHILIPS NV) 01 June 1978 (1978-06-01) <br> entire document | 1-10 |
| A | CN 102710135 A (BEIJING INSTITUTE OF MECHANICAL EQUIPMENT) 03 October 2012 (2012-10-03) <br> entire document | 1-10 |
| A | CN 101521454 A (ZTE CORPORATION) 02 September 2009 (2009-09-02) <br> entire document | 1-10 |
| A | CN 103812508 A (ZTE CORPORATION) 21 May 2014 (2014-05-21) <br> entire document | 1-10 |

☐ Further documents are listed in the continuation of Box C.    ☑ See patent family annex.

| | |
|---|---|
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **27 August 2019** | **02 September 2019** |

| Name and mailing address of the ISA/CN | Authorized officer |
|---|---|
| **China National Intellectual Property Administration** <br> **No. 6, Xitucheng Road, Jimenqiao Haidian District, Beijing 100088** <br> **China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2019/088540**

| Patent document cited in search report | | | Publication date (day/month/year) | Patent family member(s) | | | Publication date (day/month/year) |
|---|---|---|---|---|---|---|---|
| CN | 103580450 | A | 12 February 2014 | US | 2015180342 | A1 | 25 June 2015 |
| | | | | WO | 2013185661 | A1 | 19 December 2013 |
| | | | | CN | 103580450 | B | 29 March 2017 |
| | | | | US | 9570984 | B2 | 14 February 2017 |
| | | | | EP | 2863525 | A4 | 21 October 2015 |
| | | | | EP | 2863525 | A1 | 22 April 2015 |
| CN | 103441491 | A | 11 December 2013 | CN | 103441491 | B | 20 January 2016 |
| CN | 101667729 | A | 10 March 2010 | WO | 2011044806 | A1 | 21 April 2011 |
| | | | | EP | 2477296 | A4 | 01 May 2013 |
| | | | | RU | 2012117957 | A | 20 November 2013 |
| | | | | ES | 2585256 | T3 | 04 October 2016 |
| | | | | CN | 101667729 | B | 25 March 2015 |
| | | | | EP | 2477296 | B1 | 11 May 2016 |
| | | | | US | 2012204053 | A1 | 09 August 2012 |
| | | | | US | 8392730 | B2 | 05 March 2013 |
| | | | | RU | 2504885 | C1 | 20 January 2014 |
| | | | | EP | 2477296 | A1 | 18 July 2012 |
| DE | 2751696 | A1 | 01 June 1978 | US | 4150426 | A | 17 April 1979 |
| | | | | JP | S5752787 | B2 | 09 November 1982 |
| | | | | GB | 1525544 | A | 20 September 1978 |
| | | | | DE | 2751696 | B2 | 21 December 1978 |
| | | | | JP | S5368821 | A | 19 June 1978 |
| | | | | DE | 2751696 | C3 | 08 August 1985 |
| CN | 102710135 | A | 03 October 2012 | None | | | |
| CN | 101521454 | A | 02 September 2009 | CN | 101521454 | B | 23 May 2012 |
| CN | 103812508 | A | 21 May 2014 | RU | 2632820 | C2 | 10 October 2017 |
| | | | | CN | 103812508 | B | 15 March 2019 |
| | | | | WO | 2013167003 | A1 | 14 November 2013 |
| | | | | EP | 2852257 | A1 | 25 March 2015 |
| | | | | JP | 2015523844 | A | 13 August 2015 |
| | | | | EP | 2852257 | A4 | 02 September 2015 |
| | | | | RU | 2015103946 | A | 10 January 2017 |
| | | | | US | 2015130426 | A1 | 14 May 2015 |
| | | | | JP | 6125006 | B2 | 10 May 2017 |
| | | | | IN | 1DEN2015 | A | 22 May 2015 |
| | | | | US | 9467041 | B2 | 11 October 2016 |

Form PCT/ISA/210 (patent family annex) (January 2015)